# EUROPEAN PATENT SPECIFICATION

(11) **EP 3 324 530 B1**
(45) Date of publication and mention of the grant of the patent: **19.05.2021**
(21) Application number: 17197404.1
(22) Date of filing: 19.10.2017
(51) Int. Cl.: H02M 7/00

(54) **LIGHTWEIGHT AND COMPACT CONVERTER VALVE FOR FLEXIBLE DIRECT CURRENT POWER TRANSMISSION AND CONVERTER VALVE COMPONENT THEREOF**
LEICHTES UND KOMPAKTES WANDLERVENTIL FÜR FLEXIBLE GLEICHSTROMÜBERTRAGUNG UND WANDLERVENTILKOMPONENTE DAVON
SOUPAPE DE CONVERTISSEUR LÉGÈRE ET COMPACTE POUR TRANSMISSION DE PUISSANCE À COURANT CONTINU FLEXIBLE ET COMPOSANT DE SOUPAPE DE CONVERTISSEUR CORRESPONDANT

(30) Priority: 18.11.2016 CN 201611016158
(43) Date of publication of application: 23.05.2018
(73) Proprietor: XJ Electric Co., Ltd, Xuchang City, Henan (CN); XJ Group Corporation, Xuchang City, Henan (CN); State Grid Corporation of China, Beijing (CN)
(72) Inventor: ZHANG, Cheng, Xuchang City, Henan (CN); ZHU, Xinhua, Xuchang City, Henan (CN); LI, Huajun, Xuchang City, Henan (CN); JIA, Yanling, Xuchang City, Henan (CN); WANG, Yan, Xuchang City, Henan (CN); WANG, Jianyun, Xuchang City, Henan (CN); ZHANG, Xiaoge, Xuchang City, Henan (CN); YU, Liyang, Xuchang City, Henan (CN)
(74) Representative: White, Andrew John

(56) References cited:
- CN-A- 105 006 474
- CN-B- 103 354 232

## Description

### TECHNICAL FIELD

The disclosure relates to a lightweight and compact converter valve for flexible direct current power transmission and a converter valve component thereof.

### BACKGROUND

A flexible direct current power transmission technology is a novel direct current power transmission technology based on a voltage source converter, a turn-off device and a pulse width modulation technology. Compared with a conventional thyristor-based current source type direct current power transmission technology, the flexible direct current power transmission technology adopts a fully-controlled power electronic device, i.e. an Insulated Gate Bipolar Transistor (IGBT), is high in system reaction speed, higher in controllability and flexible in running manner, may reduce a system short-circuit capacity and improve power quality, and has obvious advantages in the aspects of renewable energy resource grid connection, distributed power generation grid connection, island power supply, urban power grid supply and the like.

Most of current domestic and abroad flexible direct current power transmission converter valve sub-modules adopt a single-module independent inserted structure, and most of IGBTs adopt conventional IGBTs. A parallel sub-module for flexible direct current power transmission is disclosed in Chinese patent application No. CN103354232A, published on October 16, 2013, and such a parallel sub-module includes a capacitor, two IGBT power units and two main busbars, herein each IGBT power unit includes a radiator, more than two parallel IGBT sub-modules and control loops thereof, each power unit further includes a composite busbar, the capacitor is connected with the corresponding IGBT power unit through capacitor connecting ends at upper ends of the composite busbars, the two main busbars are connected with the corresponding IGBT power units through outlet ends arranged on the two composite busbars, and moreover, a thyristor is conductively connected between the two main busbars.

Such a parallel sub-module is used as an independent sub-module. Due to a layout of IGBTs and the thyristor in each sub-module, a single module, as an independent whole, may be inserted and fixed on a mounting substrate, and it is necessary to clamp and fix each single module by adopting a crimping fixing structure. Such an independent sub-module mounting structure has the following major shortcomings: first, each independent sub-module is required to be independently crimped, so that many crimping components of various types are required, a mounting task is heavy, and cost is high; second, each independent sub-module is required to be structurally independent, and for ensuring an insulating spacing, a large dimensional design of the whole valve component is required, so that an overall dimension of a valve tower of a converter valve is enlarged; and third, wiring in the sub-modules and between the sub-modules is complex, and it is necessary to consider a requirement on an internal electrical insulating distance, so that difficulties in component design are increased, and a structural design is cumbersome.

A flexible direct current power transmission converter valve component and an IGBT sub-module thereof are disclosed in a patent No. CN105006474A, published on October 28, 2015. The converter valve component includes a mounting frame, on the mounting frame is equipped with a spring crimping structure, the spring crimping structure includes a middle frame and two end plates, a disk spring structure is arranged on one of the two end plates, a pressing structure is arranged on the other end plate, at least two sub-modules and inter-module insulating stopper are sequentially and alternately arranged on the middle frame along a left-right direction, each sub-module includes two IGBTs, three radiators and a thyristor, the two IGBTs and the three radiators are sequentially arranged at intervals along the left-right direction, the thyristor is arranged on an outer side of the rightmost radiator, the corresponding surface of the thyristor is fixedly mounted on outer lateral surface of the rightmost radiator, and conductive aluminum bars, which cooperates with the rightmost radiators to clamp the thyristors, are arranged on right sides of the thyristors. Multiple sub-modules may be crimped in series by using the disk spring structure and pressing structure in the spring crimping structure, so that a crimping fixing structure for the sub-modules in the whole converter valve component may be effectively simplified.

According to the abovementioned converter valve component, the thyristors and the IGBTs are crimped into a large valve section, and the valve section is longer in dimension. The thyristors and the IGBTs are inconsistent in dimension, so that appearance is not beautiful. Moreover, different pressing forces may be born when the thyristors and the IGBTs are crimped, and it is difficult to control sizes of the pressing forces in a crimping process, so that it is difficult to crimp the valve section.

### SUMMARY

The disclosure is intended to provide a converter valve component, so as to solve the problem of difficulties in crimping when a thyristor and an IGBT are simultaneously crimped, and is also intended to provide a lightweight and compact converter valve, including the converter valve component, for flexible direct current power transmission.

In order to achieve the above purposes, the technical solution of the converter valve component of the disclosure is as follows: a converter valve component may include a mounting frame, at least one IGBT unit and at least one thyristor unit, wherein an IGBT and radiators of the IGBT unit may be crimped together through an IGBT spring crimping structure, a thyristor of the thyristor unit may be crimped through a thyristor spring crimping structure, and the IGBT spring crimping structure may be arranged on the mounting frame.

There may be multiple IGBT units, every two adjacent IGBT units may be spaced out through an insulating part, the IGBT spring crimping structure may include an IGBT spring crimping unit, and all IGBT units may be crimped together through the IGBT spring crimping unit.

There may be multiple thyristor units, the thyristor spring crimping structure may include multiple thyristor spring crimping units with a same number as same as that of the thyristor units, and the thyristor of each thyristor unit may be crimped through the corresponding thyristor spring crimping unit.

There may be multiple IGBT units connected in series, there may be multiple thyristor units connected in series, and the multiple IGBT units and the multiple thyristor units may be connected in parallel.

There may be multiple IGBT units and multiple thyristor units forming a string structure extending along a left-right direction, and the thyristor units may be positioned below the IGBT units.

The thyristor units may be positioned in a frame formed by the mounting frame, and the IGBT units may be mounted above the mounting frame through a support plate to increase a height of the IGBT unit.

Each IGBT unit may correspond to a control unit, multiple control units may form a string structure extending along the left-right direction, the control units may be positioned above the IGBT units, and mounting brackets for mounting the corresponding control units may be arranged on the radiators in the IGBT units.

Capacitor units corresponding to the IGBT units one to one may further be arranged on the mounting frame, multiple capacitor units may form a string structure extending along the left-right direction, and the capacitor units may be positioned behind the IGBT units.

The mounting frame may include conductive support beams for mounting the IGBT units and conducted with an adjacent converter valve component, the mounting frame may further include insulating support beams for mounting capacitors, guide rails for guiding and mounting the capacitors may be arranged on the insulating support beams, and balls may be mounted on the guide rails.

The technical solution of the lightweight and compact converter valve for flexible direct current power transmission of the disclosure is as follows: a flexible direct current power transmission converter valve may include at least two converter valve components, structures of the converter valve components being consistent with a structure of the abovementioned converter valve component.

The disclosure has the following beneficial effects: the IGBT and radiators in the IGBT unit are crimped through the IGBT spring crimping structure, the thyristor in the thyristor unit is crimped through the thyristor spring crimping structure, the IGBT spring crimping structure and the thyristor spring crimping structure are two independent spring crimping structures, the IGBT unit and the thyristor unit are independently crimped, and compared with crimping of an IGBT and a thyristor together in a prior art, it is only necessary to consider a pressing force required by the IGBT unit and a pressing force required by the thyristor unit respectively, so that the pressing forces are convenient to control, and a crimping process is simple and easy to operate.

### BRIEF DESCRIPTION OF DRAWINGS

Fig. 1 is a schematic diagram of a converter valve component embodiment of the disclosure.
Fig. 2 is a schematic diagram of a mounting frame in a converter valve component embodiment of the disclosure.
Fig. 3 is a schematic diagram of an IGBT component in a converter valve component embodiment of the disclosure.
Fig. 4 is a schematic diagram of a control element in a converter valve component embodiment of the disclosure.
Fig. 5 is a schematic diagram of independent crimping of thyristors in a converter valve component embodiment of the disclosure.

### DETAILED DESCRIPTION

Implementation modes of the disclosure will be further described below in combination with the drawings.

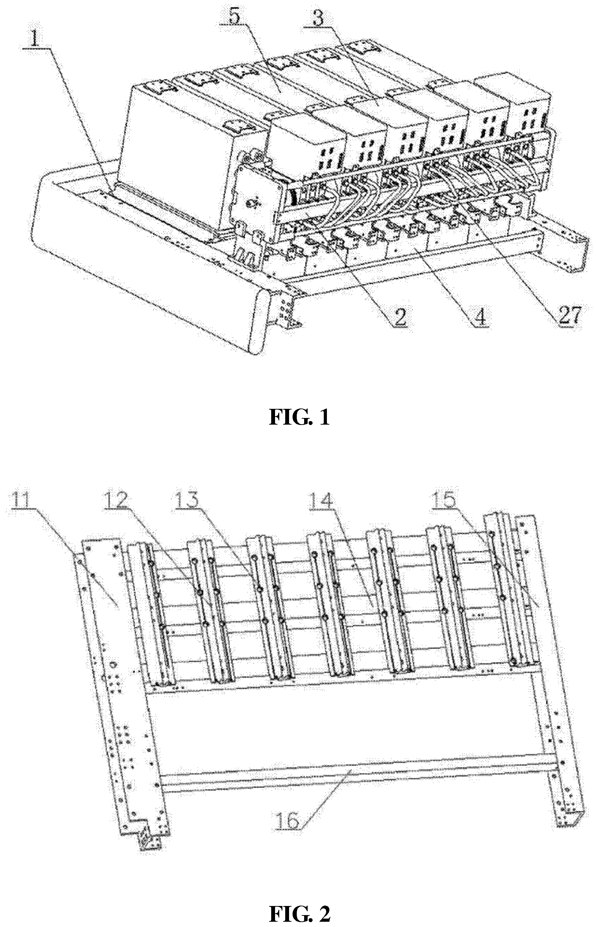

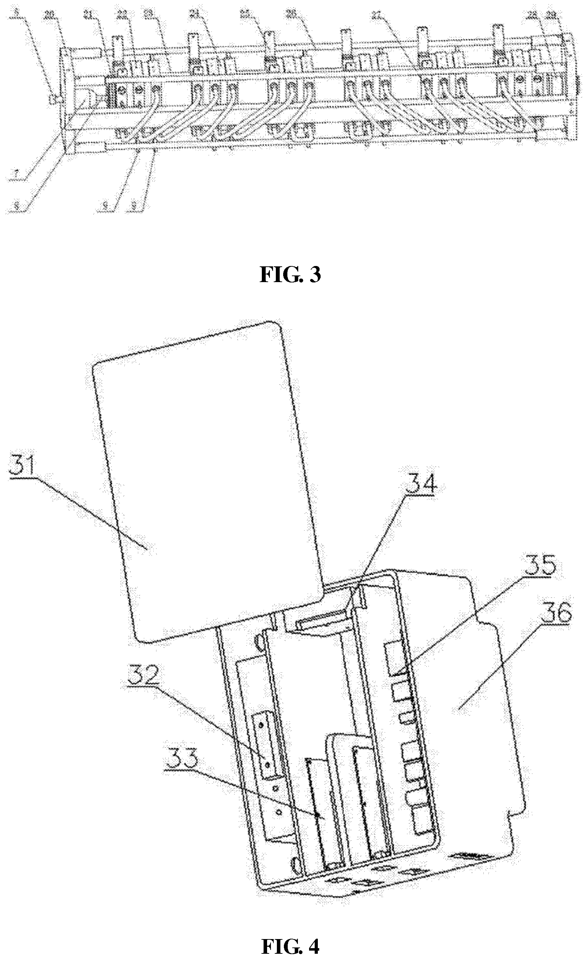

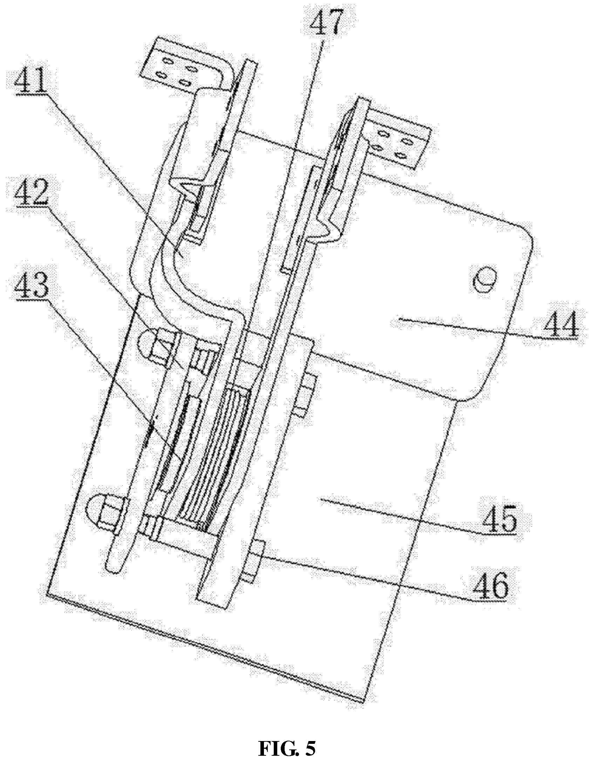

A specific embodiment of a converter valve component of the disclosure is shown in Fig. 1 to Fig. 5, specifically, 1 is a mounting frame, and the mounting frame 1 includes a left-side support beam 11, guide rails 12, balls 13, first insulating support beams 14, a right-side support beam 15 and a second insulating support beam 16; 2 is an IGBT component, and the IGBT component 2 includes an adjusting bolt 6, a left end plate 20, an insulating grid 21, radiators 22, insulating columns 23, IGBTs 24, control unit rapid-mounting brackets 25, insulating rods 26, water pipes 27, disk springs 28 and a right end plate 29; 3 is a control component, and the control component 3 includes a first shell 31, a first power supply and control source 32, a first circuit board 33, a second power supply and control source 34, a second circuit board 35 and a second shell 36; 4 is a thyristor component, and the thyristor component 4 includes busbars 41, end plates 42, a disk spring 43, bypass switches 44, mounting plates 45, pressing studs 46 and thyristors 47; and 5 is a capacitor component.

The left-side support beam 11, right-side support beam 15, first insulating support beams 14 and second insulating support beam 16 in the mounting frame 1 form a peripheral frame, the first insulating support beams 14 and the second insulating support beam 16 extend along a left-right direction, there are three first insulating support beams 14 which are parallel to one another, the guide rails 12 extending along a front-back direction are arranged on the first insulating support beams 14, and there are multiple guide rails 12 arranged in the left-right direction in parallel at intervals. Grooves (not marked in the figures) are formed in upper surfaces of the guide rails 12, and the balls 13 are embedded into the grooves. The guide rails 12 are arranged mainly to conveniently push capacitors during mounting. The capacitors are heavier, pushing and pulling of the capacitors may be rapidly realized by the embedded balls 13 during mounting and maintenance, and in addition, the guide rails may limit the capacitors which are pushed and pulled, so that assembling efficiency of the capacitors is improved.

The IGBT component 2 includes multiple IGBT units and the insulating columns 23 between every two adjacent IGBT units, each IGBT unit includes an IGBT 24 and radiators 22 on two sides of the IGBT 24, and the multiple IGBT units and the insulating columns 23 form a string extending along the left-right direction. The IGBT units and the insulating columns 23 are crimped through a IGBT spring crimping unit of an IGBT spring crimping structure. In the embodiment, there is only one IGBT spring crimping unit, the IGBT spring crimping unit includes a pressing frame formed by the left end plate 20, the right end plate 29, four insulating rods 26 and the disk springs 28, a guide sleeve 7 is fixed at a right end of the left end plate 20, a transmission shaft 8 is mounted in the guide sleeve 7 in a sliding manner, the left end plate 20 is provided with a threaded hole penetrating through the left-right direction, the adjusting bolt 6 is mounted in the threaded hole in a penetration manner, a ball head (not shown in the figures) is arranged at a right end of the adjusting bolt 6, and the ball head may push the transmission shaft 8 to slide leftwards and rightwards in the guide sleeve 7. The disk springs 28 are fixed on an inner side of the right end plate 29. The multiple IGBT units formed by the IGBTs 24 and the radiators 22 on the left and right sides of the IGBTs 24 are mounted between the left end plate 20 and the right end plate 29, the insulating columns 23 are arranged between every two adjacent IGBT units, and the insulating columns 23 may prolong electrical creepage distances between every two adjacent IGBT units and improve electrical performance and insulating performance between the adjacent IGBT units. The insulating grid 21 is arranged between the IGBT unit on a leftmost side and the transmission shaft 8, and the insulating grid 21 may prolong an insulating distance between the IGBT component and an adjacent IGBT component. During mounting, the adjusting bolt 6 is regulated to press the IGBT units to make the IGBTs and the radiators form close contact and conducted. Conductive bars 9 extending out of the pressing frame are arranged on the radiators, and each conductive bar 9 is connected with the conductive bars 9 of adjacent IGBT units to realize series connection. The control unit rapid-mounting brackets 25 are further arranged on the radiators 22 of each IGBT unit to facilitate rapid and one-to-one corresponding mounting of control units at an upper end of each IGBT unit. The multiple radiators 2 are connected in series for cyclic radiation, and the water pipes 27 are connected to each radiator 22 to realize cyclic radiation.

The control component 3 includes multiple control units, the control component includes the first shell 31 and the second shell 36, the two shells form an enclosed shell structure, the shell structure has good waterproof and dustproof functions, the first circuit board 33, the second circuit board 35, the first power supply and control source 32 and the second power supply and control source 34 are integrally mounted to make the control unit compact in overall structure and delicate in appearance. Each control unit corresponds to an IGBT unit, is rapidly connected with the corresponding control unit rapid-mounting bracket 25 through a bolt, and is mounted and maintained conveniently and reliably.

The thyristor component 4 includes multiple thyristor units, each thyristor unit is distributed along the left-right direction, each thyristor unit includes a thyristor, each thyristor corresponds to a thyristor crimping unit, and all of the thyristor crimping units form a thyristor crimping structure. Each thyristor crimping unit includes the end plates 42, the end plates 42 includes left and right end plates, the disk spring 43 is arranged on one end plate, the left and right end plates and the disk spring 43 press, under a pressing action of the pressing studs 46, the thyristor 47 to enable the thyristor 47 to locate between the left and right end plates, two busbars 41 are extended from the thyristor 47, and every two adjacent thyristor units are connected in series through the busbars 41 to form the thyristor component 4. Each thyristor further corresponds to a mounting plate 45 and a bypass switch 44, and the bypass switch 44 is used for controlling a single thyristor.

The capacitor component 5 is further arranged behind the IGBT component 2, the capacitor component 5 includes multiple capacitors distributed along the left-right direction, and each capacitor corresponds to an IGBT unit.

The converter valve component includes the mounting frame 1, the IGBT component 2, the control component 3, the thyristor component 4 and the capacitor component 5, the thyristor component 4 is pressed between the left-side support beam 11 and the right-side support beam 15, a support plate is mounted on the left-side support beam 11 and the right-side support beam 15, a height of the support plate is not smaller than a height of the thyristor component 4, the IGBT component is mounted on the support plate, the left end plate 20 and the right end plate 29 of the IGBT component are fixed on the support plate, and the IGBT component is fixed on the mounting frame through the support plate. During mounting, it is necessary to ensure that there is no structural interference between the IGBT component and the thyristor component 4 when the IGBT component is mounted above the thyristor component 4. The control units corresponding to the IGBT units one to one are mounted above the IGBT component, and the multiple control units form the control component 3. The capacitors corresponding to the IGBT units one to one are mounted behind the IGBT component 2, and the multiple capacitors form the capacitor component.

During mounting, the multiple IGBT units and insulating columns between the adjacent IGBT units in the IGBT component are crimped through the IGBT crimping unit, the thyristor of each thyristor unit in the thyristor component is crimped through the corresponding thyristor crimping unit, then the capacitors are mounted at a rear part of the mounting frame through the guide rails, then the thyristor component is mounted, the IGBT component is mounted, the control units are finally mounted, and electrical connection between all units is finished.

In the embodiment, the left-side support beam 11 and the right-side support beam 15 in the mounting frame are conductive structures, and form conductive support beams, the busbars of the thyristor component and the conductive bars of the IGBT component are connected to the support beams on the left and right sides to realize conduction, the thyristor component and the IGBT component are connected in parallel, and electrical connection between converter valve components is directly externally realized through the support beams on the left and right sides, so that many cumbersome busbars and fixing support elements are reduced, and structure of a converter valve is simplified.

In the embodiment, the IGBTs and the radiators on the two sides of the IGBTs form the IGBT units, the IGBT spring crimping structure includes the IGBT spring crimping unit, and the IGBT spring crimping unit presses all the IGBT units and the insulating columns between the units together. In other embodiments, the IGBT spring crimping structure may include multiple IGBT spring crimping units, each IGBT spring crimping unit corresponds to an IGBT unit, and then the independently crimped IGBT units are connected in series to form the IGBT component.

In the embodiment, each thyristor unit corresponds to a thyristor crimping unit, and the multiple thyristor crimping units form the thyristor crimping structure. In other embodiments, the multiple thyristor units may be distributed along a straight line, then the multiple thyristor units are crimped together from the two sides, and at this moment, each thyristor crimping structure includes only one thyristor crimping unit.

In the embodiment, the IGBT spring crimping unit includes the adjusting bolt, the guide sleeve, the transmission shaft, the left end plate, the right end plate and the disk spring.

In other embodiments of the disclosure, positions of the IGBT component, the thyristor component, the control component and the capacitor component may be regulated according to a practical condition.

According to a specific embodiment of a lightweight and compact converter valve for flexible direct current power transmission of the disclosure, the lightweight and compact converter valve for flexible direct current power transmission includes at least two converter valve components, structures of the converter valve components are consistent with a structure of the abovementioned converter valve component, and contents thereof will not be elaborated herein.

## Claims

1. A converter valve component, comprising a mounting frame (1), a plurality of Insulated Gate Bipolar Transistor (IGBT) units (2) and a plurality of thyristor units (4), wherein
the plurality of IGBT units forms a string structure extending along a left-right direction, the plurality of thyristor units forms a string structure extending along the left-right direction, and the plurality of thyristor units are positioned below the plurality of IGBT units;
IGBTs (24) and radiators (22) of the plurality of IGBT units are crimped together through an IGBT spring crimping structure, every two adjacent IGBT units are spaced out through an insulating part (23), the IGBT spring crimping structure comprises one IGBT spring crimping unit, and all IGBT units are crimped together through the IGBT spring crimping unit;
a thyristor of the thyristor unit is crimped through a thyristor spring crimping structure, the thyristor spring crimping structure comprises a plurarity of thyristor spring crimping units with a same number as same as that of the thyristor units, and the thyristor of each thyristor unit is crimped through the corresponding thyristor spring crimping unit; and
the IGBT spring crimping structure is arranged on the mounting frame.

2. The converter valve component according to claim 1, wherein the plurality of IGBT units are connected in series, the plurality of thyristor units are connected in series, and the plurality of IGBT units and the plurality of thyristor units are connected in parallel.

3. The converter valve component according to claim 1, wherein the thyristor units are positioned in a frame formed by the mounting frame, and the IGBT units are mounted above the mounting frame through a support plate to increase a height of the IGBT units.

4. The converter valve component according to claim 1, wherein each IGBT unit corresponds to a control unit (3), a plurality of control units form a string structure extending along the left-right direction, the control units are positioned above the IGBT units, and mounting brackets for mounting the corresponding control units are arranged on the radiators in the IGBT units.

5. The converter valve component according to claim 1, wherein capacitor units (5) corresponding to the IGBT units one to one are further arranged on the mounting frame, a plurality of capacitor units form a string structure extending along the left-right direction, and the capacitor units are positioned behind the IGBT units.

6. The converter valve component according to claim 1, wherein the mounting frame (1) comprises conductive support beams (11, 15) for mounting the IGBT units and conducted with an adjacent converter valve component, the mounting frame further comprises insulating support beams (14, 16) for mounting capacitors, guide rails (12) for guiding and mounting the capacitors are arranged on the insulating support beams, and balls are mounted on the guide rails.

7. A lightweight and compact converter valve for flexible direct current power transmission, comprising at least two converter valve components according to any one of claims 1-6.

## Patentansprüche

1. Wandlerventilkomponente, die einen Montagerahmen (1), mehrere IGBT-(Insulated Gate Bipolar Transistor)-Einheiten (2) und mehrere Thyristor-Einheiten (4) umfasst, wobei
die mehreren IGBT-Einheiten eine sich in Links-Rechts-Richtung erstreckende Stringstruktur bilden, die mehreren Thyristor-Einheiten eine sich in Links-Rechts-Richtung erstreckende String-Struktur bilden und die mehreren Thyristor-Einheiten unterhalb der mehreren IGBT-Einheiten positioniert sind;
IGBTs (24) und Strahler (22) der mehreren IGBT-Einheiten durch eine IGBT-Federcrimpstruktur zusammengecrimpt sind, jeweils zwei benachbarte IGBT-Einheiten durch ein Isolierteil (23) beabstandet sind, die IGBT-Federcrimpstruktur eine IGBT-Federcrimpeinheit umfasst und alle IGBT-Einheiten durch die IGBT-Federcrimpeinheit zusammengecrimpt sind;
ein Thyristor der Thyristoreinheit durch eine Thyristor-Federcrimpstruktur gecrimpt wird, die Thyristor-Federcrimpstruktur mehrere Thyristor-Federcrimpeinheiten mit einer gleichen Anzahl wie die der Thyristoreinheiten umfasst, und der Thyristor jeder Thyristoreinheit durch die entsprechende Thyristor-Federcrimpeinheit gecrimpt wird; und
die IGBT-Federcrimpstruktur am Montagerahmen angeordnet ist.

2. Wandlerventilkomponente nach Anspruch 1, wobei die mehreren IGBT-Einheiten in Reihe geschaltet sind, die mehreren Thyristoreinheiten in Reihe geschaltet sind und die mehreren IGBT-Einheiten und die mehreren Thyristoreinheiten parallel geschaltet sind.

3. Wandlerventilkomponente nach Anspruch 1, wobei die Thyristoreinheiten in einem durch den Montagerahmen gebildeten Rahmen positioniert sind und die IGBT-Einheiten oberhalb des Montagerahmens durch eine Trägerplatte montiert sind, um eine Höhe der IGBT-Einheiten zu vergrößern.

4. Wandlerventilkomponente nach Anspruch 1, wobei jede IGBT-Einheit einer Steuereinheit (3) entspricht, mehrere Steuereinheiten eine sich in Links-Rechts-Richtung erstreckende Stringstruktur bilden, die Steuereinheiten oberhalb der IGBT-Einheiten positioniert sind, und an den Strahlern in den IGBT-Einheiten Halterungen zum Montieren der entsprechenden Steuereinheiten angeordnet sind.

5. Wandlerventilkomponente nach Anspruch 1, wobei ferner den IGBT-Einheiten entsprechende Kondensatoreinheiten (5) eins zu eins am Montagerahmen angeordnet sind, mehrere Kondensatoreinheiten eine sich in Links-Rechts-Richtung erstreckende Strangstruktur bilden und die Kondensatoreinheiten hinter den IGBT-Einheiten angeordnet sind.

6. Wandlerventilkomponente nach Anspruch 1, wobei der Montagerahmen (1) leitfähige Träger (11, 15) zum Montieren der IGBT-Einheiten aufweist, geleitet mit einer benachbarten Wandlerventilkomponente, der Montagerahmen ferner isolierende Träger (14, 16) zum Montieren von Kondensatoren aufweist, an den isolierenden Trägern Führungsschienen (12) zum Führen und Montieren der Kondensatoren angeordnet sind und an den Führungsschienen Kugeln montiert sind.

7. Leichtes und kompaktes Wandlerventil zur flexiblen Gleichstrom-Leistungsübertragung, das mindestens zwei Stromrichterventil-Komponenten nach einem der Ansprüche 1-6 umfasst.

## Revendications

1. Composant de valve de convertisseur, comprenant un bâti de montage (1), une pluralité d'unités transistor bipolaire à grille isolée (IGBT) (2) et une pluralité d'unités thyristor (4), dans lequel :
la pluralité d'unités IGBT forme une structure en chaîne qui s'étend suivant une direction de gauche à droite, la pluralité d'unités thyristor forme une structure en chaîne qui s'étend suivant la direction de gauche à droite et la pluralité d'unités thyristor est positionnée sous la pluralité d'unités IGBT ;
des IGBT (24) et des radiateurs (22) de la pluralité d'unités IGBT sont sertis ensemble par l'intermédiaire d'une structure à ressort de sertissage d'IGBT, deux unités IGBT adjacentes successives sont espacées par une pièce isolante (23), la structure à ressort de sertissage d'IGBT comprend une unité à ressort de sertissage d'IGBT et toutes les unités IGBT sont serties ensemble par l'intermédiaire de l'unité à ressort de sertissage d'IGBT ;
un thyristor de l'unité thyristor est serti par l'intermédiaire d'une structure à ressort de sertissage de thyristor, la structure à ressort de sertissage de thyristor comprend une pluralité d'unités à ressort de sertissage de thyristor avec un même nombre que celui des unités thyristor, et le thyristor de chaque unité thyristor est serti par l'intermédiaire de l'unité à ressort de sertissage de thyristor correspondante ; et
la structure à ressort de sertissage d'IGBT est agencée sur le bâti de montage.

2. Composant de valve de convertisseur selon la revendication 1, dans lequel la pluralité d'unités IGBT sont connectées en série, la pluralité d'unités thyristor sont connectées en série, et la pluralité d'unités IGBT et la pluralité d'unités thyristor sont connectées en parallèle.

3. Composant de valve de convertisseur selon la revendication 1, dans lequel les unités thyristor sont positionnées dans un bâti formé par le bâti de montage, et les unités IGBT sont montées au-dessus du bâti de montage par l'intermédiaire d'une plaque de support pour augmenter une hauteur des unités IGBT.

4. Composant de valve de convertisseur selon la revendication 1, dans lequel chaque unité IGBT correspond à une unité de contrôle (3), une pluralité d'unités de contrôle forment une structure en chaîne s'étendant suivant la direction de gauche à droite, les unités de contrôle sont positionnées au-dessus des unités IGBT, et des supports de montage pour monter les unités de contrôle correspondantes sont agencés sur les radiateurs dans les unités IGBT.

5. Composant de valve de convertisseur selon la revendication 1, dans lequel des unités condensateur (5) qui correspondent de façon biunivoque aux unités IGBT sont en outre agencées sur le bâti de montage, une pluralité d'unités condensateur forment une structure en chaîne s'étendant suivant la direction de gauche à droite, et les unités condensateur sont positionnées derrière les unités IGBT.

6. Composant de valve de convertisseur selon la revendication 1, dans lequel le bâti de montage (1) comprend des poutrelles de support conductrices (11, 15) pour monter les unités IGBT et conduites avec un composant de valve de convertisseur adjacent, le bâti de montage comprend en outre des poutrelles de support isolantes (14, 16) pour monter des condensateurs, des rails de guidage (12) pour guider et monter les condensateurs sont agencés sur les poutrelles de support isolantes, et des billes sont montées sur les rails de guidage.

7. Valve de convertisseur légère et compacte pour une transmission de puissance en courant continu flexible, comprenant au moins deux composants de valve de convertisseur selon l'une quelconque des revendications 1 à 6.
